# EUROPÄISCHE PATENTSCHRIFT

(11) **EP 1 459 378 B1**
(45) Veröffentlichungstag und Bekanntmachung des Hinweises auf die Patenterteilung: **22.03.2006**
(21) Anmeldenummer: 02792574.2
(22) Anmeldetag: 17.12.2002
(51) Int. Cl.: H01L 23/367

(54) **KÜHLVORRICHTUNG FÜR EINEN CHIP SOWIE VERFAHREN ZU IHRER HERSTELLUNG**
COOLING DEVICE FOR A CHIP AND METHOD FOR PRODUCTION THEREOF
DISPOSITIF DE REFROIDISSEMENT POUR PUCE, ET PROCEDE DE REALISATION

(30) Priorität: 18.12.2001 AT 19812001
(43) Veröffentlichungstag der Anmeldung: 22.09.2004
(73) Patentinhaber: Fotec Forschungs- und Technologietransfer Gmbh, 2700 Wiener Neustadt (AT)
(72) Erfinder: GRIESMAYER, Erich, A-2721 Bad Fischau-Brunn (AT)
(74) Vertreter: Miksovsky, Alexander
(86) Internationale Anmeldenummer: PCT/AT2002/000352
(87) Internationale Veröffentlichungsnummer: WO 2003/053118

(56) Entgegenhaltungen:
- WO-A-00/33622
- US-A- 4 823 869
- US-B1- 6 269 866

## Beschreibung

Die vorliegende Erfindung bezieht sich auf eine Kühlvorrichtung für einen Chip, insbesondere Prozessor, welcher von dem Chip abgewandt mit einer Vielzahl von im wesentlichen normal auf eine Basisfläche stehenden Erhebungen bzw. Finnen ausgebildet ist und an seiner zum Chip gewandten Seite über die Basisfläche am Chip festlegbar ist, wobei die Basisfläche mit einer Mehrzahl von Stegen bzw. Rippen ausgebildet ist, welche insbesondere eine Mehrzahl von durchgehenden Kanälen bei Anordnung der Basisfläche auf dem Chip ausbilden, sowie auf ein Verfahren zur Herstellung einer derartigen Kühlvorrichtung.

Insbesondere aufgrund der zunehmenden Leistung von Chips, insbesondere Mikroprozessoren, ist eine effiziente Kühlung derartiger Bauteile erforderlich, wobei in diesem Zusammenhang Kühlvorrichtungen bekannt sind, welche eine Mehrzahl von Erhebungen bzw. Finnen aufweisen und über eine Basisfläche auf einem zu kühlenden Chip angeordnet werden, wie dies beispielsweise der US-A 5 195 576, der DE-A 197 12 723, der EP-A 0 732 741 oder der DE-A 43 12 927 entnehmbar ist. Derartige bekannte Kühlvorrichtungen werden beispielsweise aus einem gut wärmeleitfähigen Metall, wie beispielsweise Aluminium oder Kupfer, beispielsweise derart hergestellt, daß ein entsprechend den Gesamtabmessungen der herzustellenden Kühlvorrichtung ausgebildeter Block durch Schneid- bzw. Fräseinrichtungen bearbeitet wird, um die Erhebungen bzw. Finnen, welche eine entsprechend große Oberfläche zur Abgabe von Wärme darstellen, auszubilden. Bei derartigen bekannten Kühlvorrichtungen, bei welchen aus einem metallischen Block die Finnen gefräst bzw. geschnitten werden, ist der überaus hohe Materialaufwand nachteilig, da ein großer Anteil des Materials, welches das Ausgangselement darstellt, beim Schneiden bzw. Fräsen entfernt wird. Darüber hinaus ist nachteilig, daß komplizierte und präzise Schneid- bzw. Fräsverfahren zur Herstellung von entsprechend kleinbauenden Kühlvorrichtungen mit einer ausreichenden Wärmeabgabeoberfläche erforderlich sind, wobei gewisse Mindestabmessungen bzw. Mindestabstände zwischen den einzelnen Erhebungen bzw. Finnen nicht unterschritten werden können. Darüber hinaus ist nachteilig, daß im wesentlichen lediglich senkrecht bzw. normal aufeinander stehende Schnittlinien bzw. Fräslinien möglich bzw. ökonomisch sinnvoll sind, so daß lediglich im wesentlichen rechteckige Finnen herstellbar sind. Weiters läßt sich selbstverständlich eine zusätzliche Kühlung, beispielsweise durch ein Einbringen von Kühlluft in das Innere von Finnen, wodurch die Oberfläche zum Abtransport von Wärme entsprechend vergrößert werden könnte bzw. ein Kühlluftstrom wenigstens teilweise direkt auf die Oberfläche des zu kühlenden Chips aufgebracht werden könnte, nicht erzielen, da derartige bekannte Kühlvorrichtungen aus einem massiven Material bzw. Block geschnitten bzw. gefräst werden.

Da mit derartigen bekannten Kühlvorrichtungen, insbesondere für äußerst leistungsstarke Chips bzw. Prozessoren, die erforderlichen Kühlleistungen nicht ohne weiteres zur Verfügung gestellt werden können, werden weiters derartige Kühlvorrichtungen mit gegenüber dem zu kühlenden Bauteil vergrößerten Abmessungen hergestellt, so daß ein übermäßiger Platzbedarf zur Verfügung gestellt werden muß und derart eine oftmals gewünschte Miniaturisierung von Geräten, in welchen derartige Chips bzw. Prozessoren aufzunehmen sind, nicht zufriedenstellend erreicht werden kann.

Zur weiteren Unterstützung der Kühlleistung wurde bei Kühlvorrichtungen der eingangs genannten Art, beispielsweise gemäß der WO 00/33622 oder der US-A 6 134 783, vorgeschlagen, im Bereich der Basisfläche eine Mehrzahl von durchgehenden Kanälen auszubilden, welche im wesentlichen parallel zueinander und linear verlaufen, so daß über die Kanäle bzw. Kühlkanäle im Bereich der Basisfläche ein Abtransport von Wärme zu den Seiten- bzw. Begrenzungsflächen der Basisfläche bzw. allgemein der Kühlvorrichtung ebenfalls möglich wird. Nachteilig bei diesen bekannten Ausführungsformen ist insbesondere die Tatsache, daß bei üblicherweise im wesentlichen rechteckig bzw. rechtwinkelig ausgebildeten Kühlvorrichtungen, welche auf eine entsprechende Formgebung der Prozessoren bzw. Chips abgestimmt sind, aus dem zentralen bzw. mittleren Bereich aufgrund der großen Weglängen innerhalb der Kühlkanäle bis zu der Austrittsmündung an der jeweiligen Seiten- bzw. Begrenzungsfläche ein rascher Abtransport von Wärme nicht bzw. nicht ohne weiteres möglich wird.

Die vorliegende Erfindung zielt nunmehr darauf ab, eine Kühlvorrichtung für einen Chip, insbesondere Prozessor, der eingangs genannten Art zur Verfügung zu stellen, mit welchem eine weitere Verbesserung der Kühlleistung möglich wird, so daß mit kleinen bzw. kleineren Kühlvorrichtungen auch bei insbesondere steigender Leistung der Prozessoren bzw. Chips ein ordnungsgemäßer Abtransport der entstehenden Wärme möglich wird. Weiters wird darauf abgezielt, insbesondere nachteilige Konfigurationen von bekannten Finnen bzw. Erhebungen zu beseitigen.

Zur Lösung dieser Aufgaben ist eine Kühlvorrichtung der eingangs genannten Art im wesentlichen dadurch gekennzeichnet, daß die Kanäle nicht-linear, insbesondere abgewinkelt, in der Basisfläche ausgebildet sind. Dadurch, daß die erfindungsgemäß im Bereich der Basisfläche vorgesehenen Kanäle bzw. Kühlkanäle nicht-linear, insbesondere abgewinkelt sind, wird möglich, daß der Abtransport der entstehenden Wärme über im Vergleich zu einer linearen Ausbildung von Kühlkanälen für den Großteil der Kühlkanäle verkürzte Wege zu den jeweiligen Mündungen der Kühlkanäle am Randbereich der Basisfläche durchgeführt wird. Durch Vorsehen der Stege bzw. Rippen im Bereich der Basiskanäle zur Ausbildung der Kanäle bzw. Kühlkanäle, welche erfindungsgemäß nicht-linear, insbesondere abgewinkelt, ausgebildet sind, kann eine entsprechend erhöhte Wärmeabfuhr auch im Bereich der Basisfläche, an welcher die höchste Temperatur vorliegt, erzielt werden, so daß unmittelbar von dem zu kühlenden Bauteil über die Kühlkanäle eine erste, gezielte und zuverlässige Wärmeabfuhr möglich ist, worauf in weiterer Folge durch die darüber hinaus vorgesehenen Erhebungen bzw. Finnen die von dem Prozessor bzw. Chip abzuführende Wärme von dem zu kühlenden Bauteil entfernt werden kann.

Zur Erzielung möglichst kurzer Wege im Bereich der Kühlkanäle in der Basisfläche der erfindungsgemäßen Kühlvorrichtung ist gemäß einer bevorzugten Ausführungsform vorgesehen, daß die Kanäle bei im wesentlichen rechtwinkeliger Basisfläche jeweils im wesentlichen normal an aneinander angrenzenden bzw. benachbarten Seiten- bzw. Begrenzungsflächen münden. Durch derartige beispielsweise jeweils in einem Quadranten insbesondere rechtwinkelig angeordnete Kühlkanäle, welche unmittelbar an jeweils aneinander angrenzenden bzw. benachbarten Seiten- bzw. Begrenzungsflächen münden, kann ein rascher Abtransport von Wärme über die Kühlkanäle erzielt werden, wobei nicht über die Kühlkanäle abtransportierbare Wärme in weiterer Folge über die Finnen bzw. Erhebungen abgeführt wird.

Gemäß einer weiters bevorzugten Ausführungsform ist vorgesehen, daß die Kanäle jeweils in einem mittleren Abschnitt der Basisfläche eine größere Höhe normal auf die Basisfläche als in Eckbereichen der Basisfläche aufweisen. Aufgrund einer derartigen, größeren Höhe der Kanäle bzw. Kühlkanäle, insbesondere in einem mittleren Abschnitt, wird für diese mittleren Kanäle bzw. Kühlkanäle ein entsprechend größerer Durchtrittsquerschnitt zur Verfügung gestellt, so daß auch bei diesen Kanälen, welche aufgrund der vorgegebenen Geometrien der erfindungsgemäßen Kühlvorrichtung relativ größere Wege bzw. Durchtrittswege im Bereich der Basisfläche erfordern, ein zuverlässiger Wärmeabtransport sichergestellt werden kann. Darüber hinaus läßt sich durch diesen größeren Querschnitt sicherstellen, daß gegebenenfalls in einem zentralen Bereich eines zu kühlenden Bauteils entstehende, größere Wärmemengen zuverlässig abgeführt bzw. abgeleitet werden können.

Gemäß einer weiters bevorzugten Ausführungsform ist vorgesehen, daß die Erhebungen bzw. Finnen eine wenigstens teilweise bogenförmige, insbesondere kreisrunde Umfangsform im Querschnitt aufweisen. Dadurch, daß bei der erfindungsgemäßen Kühlvorrichtung die Erhebungen bzw. Finnen eine wenigstens teilweise bogenförmige Umfangsform bzw. Querschnittsform aufweisen, gelingt eine gegenüber bekannten Kühlvorrichtungen verbesserte Wärmeabgabe bzw. Wärmeabstrahlung und es können darüber hinaus insbesondere die Abstände zwischen benachbarten Finnen gegenüber bekannten Ausbildungen, bei welchen die Finnen durch ein Fräsen bzw. Schneiden aus einem vollen Block hergestellt wurden, verringert werden, so daß insgesamt die Kühlleistung weiter verbessert bzw. vergrößert werden kann. Darüber hinaus lassen sich bei bogenförmigen bzw. kreisrunden Querschnittsformen gegenüber einem regelmäßigen Muster, wie dies bekannten Kühlvorrichtungen durch den Schneid- bzw. Fräsvorgang bedingt war, zueinander versetzte Muster der Finnen erzielen, so daß wiederum gezielt die Kühlleistung beeinflußt bzw. verbessert werden kann. Derartige bogenförmige bzw. kreisrunde Querschnittsformen lassen sich beispielsweise durch ein elektrochemisches bzw. galvanisches Abscheiden von Metall in entsprechenden Formen erzielen, wie dies weiter unten im Detail näher erörtert werden wird. Durch ein derartiges Verfahren gelingt es darüber hinaus, den Materialeinsatz zur Ausbildung einer erfindungsgemäßen Kühlvorrichtung gegenüber bekannten Kühlvorrichtungen, bei welchen Zwischenräume zwischen den einzelnen Erhebungen bzw. Finnen durch ein Schneiden bzw. Fräsen hergestellt wurden und somit ein großer Anteil des Ausgangsmaterials verworfen werden mußte, entsprechend zu verringern. Darüber hinaus läßt sich durch Herstellung entsprechender Formen ein Anpassen an Erfordernisse betreffend die herzustellende Kühlvorrichtung unabhängig von den Beschränkungen eines Schneid- bzw. Fräsvorgangs erzielen. Es läßt sich somit eine erfindungsgemäße Kühlvorrichtung nicht nur bei verringertem Materialeinsatz unter Erzielung erhöhter Kühlleistungen, sondern auch entsprechend angepaßt an die Erfordernisse einfach und zuverlässig herstellen.

Gemäß einer bevorzugten Ausführungsform wird vorgeschlagen, daß die Finnen hohl ausgebildet sind und an ihren von der Basisfläche abgewandten Enden jeweils eine Durchtrittsöffnung aufweisen. Durch eine hohle Innenform der Finnen bzw. Erhebungen läßt sich die für eine Wärmeabgabe zur Verfügung stehende Oberfläche entsprechend vergrößern bzw. bei dünnwandigen Finnen im wesentlichen verdoppeln, so daß der Wärmeabtransport und somit die Kühlleistung bei gleichen Außenabmessungen der Kühlvorrichtung entsprechend erhöht werden kann. Durch die vorgesehene Durchtrittsöffnung wird weiters sichergestellt, daß eine sichere Abfuhr von Wärme von der Innenoberfläche einer Finne erzielbar ist.

Insbesondere bei Vorsehen von hohlen Finnen wird gemäß einer weiters bevorzugten Ausführungsform vorgeschlagen, daß die hohlen Innenräume der Finnen wenigstens teilweise, bevorzugt im wesentlichen vollständig, in dem Bereich der Durchtrittskanäle in die Basisfläche münden, so daß sich ausgehend von den durch die Rippen bzw. Stege der Basisfläche definierten Kanälen unmittelbar auch neben einem Ausbringen über Öffnungen im Bereich des Umfangsrands der Basisfläche gezielt ein Ausbringen von Wärmeenergie durch den Innenraum der Finnen erzielen läßt, wobei die Wärmeabfuhr durch den durch die Finnen zur Verfügung gestellten Kamineffekt entsprechend begünstigt bzw. unterstützt wird. Weiters läßt sich in diesem Zusammenhang bei Vorsehen einer Zwangsbelüftung, wie dies unten noch zusätzlich erörtert werden wird, eine entsprechende Unterstützung der Wärmeabfuhr durch die durch die Kanäle der Basisfläche als auch die Innenhohlräume der Finnen definierten Querschnitte erzielen.

Ein verbesserter Wärmeabtransport durch die Finnen wird hiebei dadurch begünstigt, daß die Erhebungen bzw. Finnen eine Höhe aufweisen, welche maximal das 12-fache, insbesondere maximal das 7-fache, der Dicke bzw. des Durchmessers der Finnen beträgt, wie dies einer weiters bevorzugten Ausführungsform der erfindungsgemäßen Vorrichtung entspricht.

Insbesondere zur Unterstützung der Kaminwirkung wird gemäß einer weiter's bevorzugten Ausführungsform vorgeschlagen, daß die Finnen eine sich zu dem von der Basisfläche abgewandten Ende,verjüngende Querschnittsform aufweisen.

Zur weiteren Erhöhung der für die Wärmeabgabe wirksamen Fläche bzw. Oberfläche der erfindungsgemäßen Kühlvorrichtung wird gemäß einer weiters bevorzugten Ausführungsform vorgeschlagen, daß die Finnen eine rauhe bzw. aufgerauhte Oberfläche aufweisen.

Zur Bereitstellung einer definierten Übergangsfläche zwischen dem zu kühlenden Bauteil, dessen Außengehäuses zumindest teilweise aus einem Kunststoff besteht, an welchem die Kühlvorrichtung anzuordnen bzw. festzulegen ist, wird gemäß einer weiters bevorzugten Ausführungsform vorgeschlagen, daß die Basisfläche über eine Zwischenplatte an dem Chip festlegbar ist. Eine derartige Zwischenplatte kann aus einem entsprechend gut wärmeleitfähigen Material ausgebildet sein, welches sich zuverlässig und einfach an der Oberfläche des zu kühlenden Bauteils festlegen läßt, wobei durch eine entsprechende Materialwahl auch ein entsprechender Wärmeübergang auf die Kühlvorrichtung über die Basisfläche erzielbar ist. Insbesondere bei Vorsehen von Stegen bzw. Rippen im Bereich der Basisfläche, wodurch naturgemäß die unmittelbare Auflagefläche auf dem zu kühlenden Bauteil verringert wird, kann eine gleichmäßigere Verteilung der Wärmeabfuhr von dem zu kühlenden Bauteil durch Vorsehen einer derartigen Zwischenplatte begünstigt werden.

Für eine besonders einfache Festlegung unter gleichzeitiger Aufrechterhaltung eines guten Wärmeübergangs wird gemäß einer weiters bevorzugten Ausführungsform vorgeschlagen, daß die Zwischenplatte mit dem Chip und/oder der Basisfläche verbunden, insbesondere verlötet, ist.

Neben einer Vergleichmäßigung bzw. Vereinfachung der unmittelbaren Wärmeabfuhr von dem zu kühlenden Bauteil an die Kühlvorrichtung kann die Zwischenplatte auch zur Vereinfachung der Handhabung sowie gegebenenfalls zur Festlegung von Zusatzelementen, insbesondere im Bereich der Kühlvorrichtung, vorgesehen sein, wobei in diesem Zusammenhang gemäß einer weiters bevorzugten Ausführungsform vorgeschlagen wird, daß die Zwischenplatte die Außenabmessungen des Chips und/oder der Basisfläche der Kühlvorrichtung übersteigt.

Eine derartige Zusatzvorrichtung kann beispielsweise zur Erhöhung der Kühlleistung von einem Gebläse bzw. Ventilator gebildet sein, wobei in diesem Zusammenhang vorgeschlagen wird, daß an der Zwischenplatte eine Haltevorrichtung für einen Ventilator vorgesehen bzw. festlegbar ist, wie dies einer weiteren, bevorzugten Ausführungsform der erfindungsgemäßen Kühlvorrichtung entspricht.

Zur Erzielung der erforderlichen Kühlleistung bei insbesondere kleinbauenden Außenabmessungen der erfindungsgemäßen Kühlvorrichtung wird gemäß einer weiters bevorzugten Ausführungsform vorgeschlagen, daß die Kühlvorrichtung und/oder die Zwischenplatte aus wärmeleitfähigem Material, insbesondere Metall, insbesondere Kupfer, Aluminium, Eisen, Silber oder Gold, hergestellt ist.

Wie bereits oben angedeutet, läßt sich zur Verringerung des Materialeinsatzes und zur Erzielung gewünschter Geometrien die Kühlvorrichtung in einem elektrochemischen Abscheidungsverfahren herstellen, wobei ein erfindungsgemäß bevorzugtes Verfahren zur Herstellung einer Kühlvorrichtung im wesentlichen dadurch gekennzeichnet, daß in einer Form, welche ein Negativ der herzustellenden Kühlvorrichtung darstellt, ein Metall, insbesondere Kupfer, elektrochemisch bzw. galvanisch abgeschieden wird.

Die Erfindung wird nachfolgend anhand von in der beiliegenden Zeichnung schematisch dargestellten Ausführungsbeispielen näher erläutert. In dieser zeigen:
Fig. 1 eine perspektivische Ansicht einer ersten Ausführungsform einer erfindungsgemäßen Kühlvorrichtung, welche auf einem Chip angeordnet ist;
Fig. 2 eine perspektivische Ansicht in vergrößertem Maßstab einer abgewandelten Ausführungsform einer erfindungsgemäßen Kühlvorrichtung mit einen hohlen Innenquerschnitt aufweisenden Erhebungen bzw. Finnen;
Fig. 3 in einer zu Fig. 2 ähnlichen Darstellung die Ausbildung gemäß Fig. 2, wobei einige der Finnen abgeschnitten bzw. weggeschnitten sind;
Fig. 4 eine schematische, perspektivische Ansicht auf eine Basisfläche einer abgewandelten Ausführungsform einer erfindungsgemäßen Kühlvorrichtung; und
Fig. 5 eine schematische Seitenansicht einer weiteren abgewandelten Ausführungsform einer erfindungsgemäßen Kühlvorrichtung, welche über eine Zwischenplatte an einem zu kühlenden Bauteil festgelegt ist.

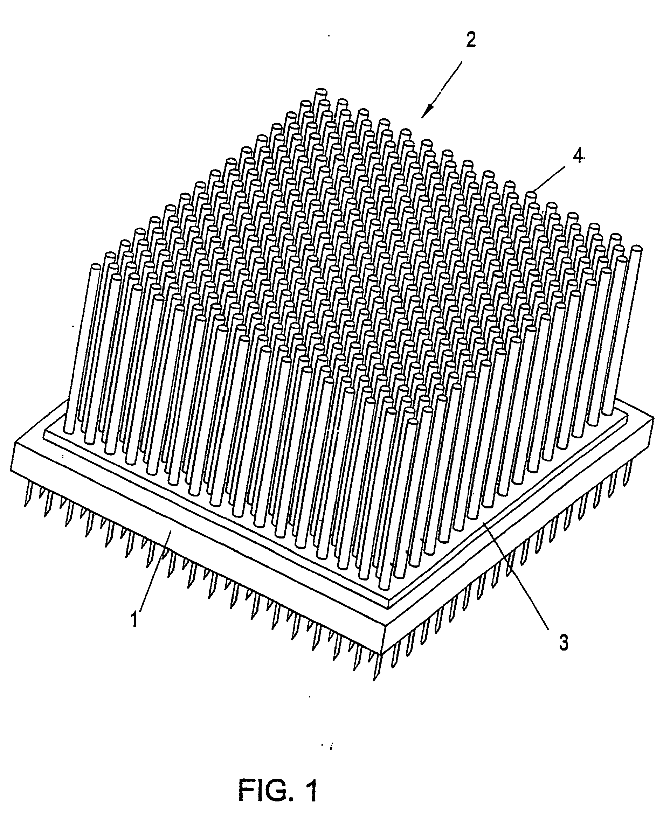

In Fig. 1 ist allgemein mit 1 ein zu kühlender Bauteil, insbesondere ein Chip bzw. Mikroprozessor, angedeutet, an welchem eine allgemein mit 2 bezeichnete Kühlvorrichtung anzuordnen bzw. festzulegen ist. Die Kühlvorrichtung 2 weist eine Basisfläche 3 auf, wobei von der Basisfläche 3 im wesentlichen normal ein Vielzahl von Erhebungen bzw. Finnen 4 vorragt, welche in der in Fig. 1 dargestellten Ausführungsform jeweils einen im wesentlichen kreisrunden Querschnitt aufweisen.

Die Kühlvorrichtung 2 gemäß Fig. 1 wird beispielsweise durch ein elektrochemisches bzw. galvanisches Abscheiden eines wärmeleitfähigen Materials, beispielsweise Kupfer, hergestellt, wobei zur Erzielung einer entsprechend großen Wärmeabgabefläche und somit einer entsprechend hohen Kühlleistung der einzelnen Finnen 4 die Finnen 4 beispielsweise einen Durchmesser von etwa 2 mm bei einem gegenseitigen Abstand benachbarter Finnen 4 von beispielsweise etwa 3 mm aufweisen. Es läßt sich somit eine Vielzahl von Finnen 4 entsprechend einem gewünschten Muster an der Basisfläche 3 ausbilden, um entsprechend der Leistung des zu kühlenden Bauteils 1 eine ausreichende Kühloberfläche zur Verfügung zu stellen.

Alternativ zu der in Fig. 1 dargestellten Ausführungsform mit im wesentlichen über die gesamte Länge der Finnen bzw. Erhebungen oder Fortsätze 4 gleichbleibendem Querschnitt kann gewünschtenfalls eine Ausbildung vorgesehen sein, bei welcher sich die Finnen zu ihren von der Basisfläche 3 abgewandten Enden insbesondere konisch verjüngen.

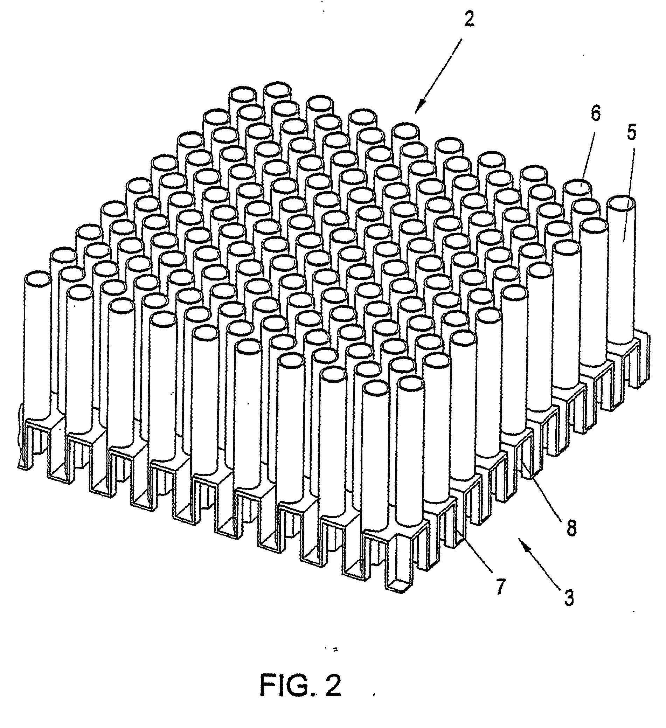

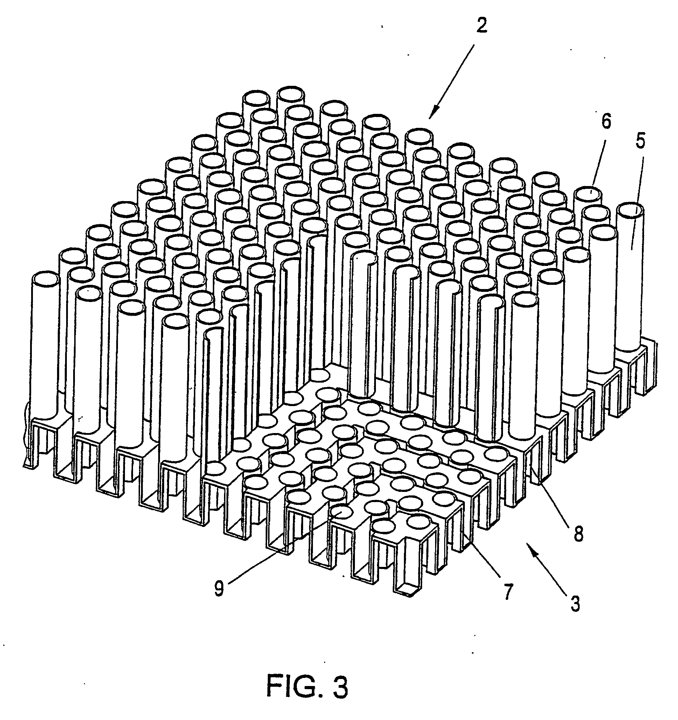

Bei der Ausbildung gemäß den Fig. 2 und 3 ist bei der wiederum mit 2 bezeichneten Kühlvorrichtung eine Mehrzahl von Finnen 5 vorgesehen, welche jeweils hohl ausgebildet sind, wobei an dem von der Basisfläche 3 abgewandten Ende jeweils ein Loch bzw. eine Öffnung 6 angedeutet ist.

Weiters ist bei der Darstellung entsprechend den Fig. 2 und 3 ersichtlich, daß die Basisfläche mit einer Mehrzahl von Rippen bzw. Stegen 7 versehen ist, zwischen welchen Durchtrittskanäle 8 im Bereich der Basisfläche 3 definiert werden.

Wie insbesondere aus der Darstellung gemäß Fig. 3 ersichtlich, sind hiebei die Stege bzw- Rippen 7 derart angeordnet, daß die dazwischen ausgebildeten, nicht-linearen Kanäle jeweils im wesentlichen rechtwinkelige Kanäle 8 in einem Quadranten der Basisfläche 3 ausbilden, wobei darüber hinaus die hohlen Finnen 5 über im Bereich der Basisfläche 3 und insbesondere im Bereich der Rippen bzw. Stege 7 vorgesehene Öffnungen bzw. Mündungen 9 wenigstens teilweise, und durch die entsprechende Formgebung der Kanäle 8 im wesentlichen vollständig, in die Kanäle 8 münden, so daß von dem nicht näher dargestellten Bauteil aufzunehmende Wärme nicht nur über die an den Seitenflächen bzw. Umfangsrändern der Basisfläche 3 mündenden Querschnitte der Kanäle 8 abgeführt werden kann, sondern Wärme aus den Kanälen 8 durch den hohlen Innenraum der Finnen 5 ebenfalls abgeführt wird.

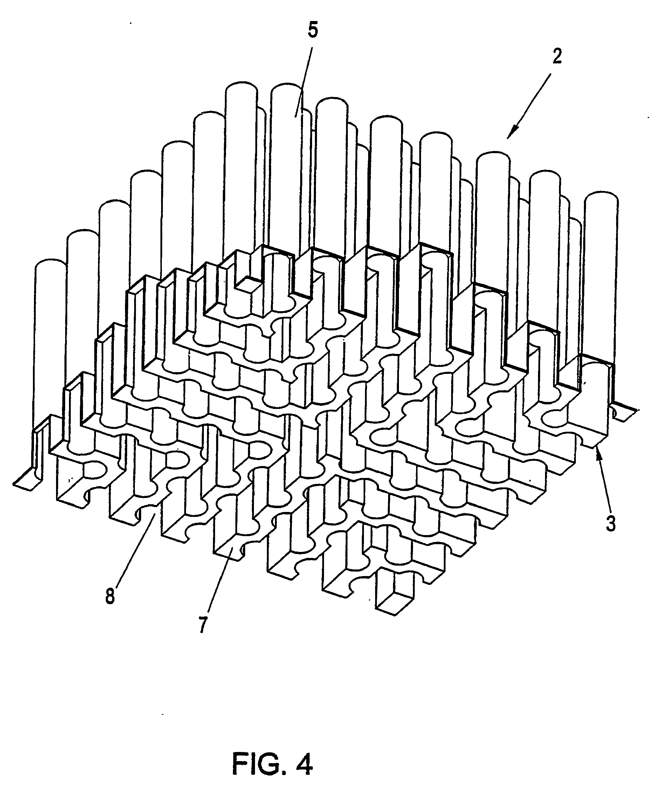

In Fig. 4 ist eine abgewandelte Ausführungsform einer Kühlvorrichtung 2 dargestellt, wobei wiederum im Bereich der Basisfläche 3 eine Vielzahl von Rippen bzw. Stegen 7 vorgesehen ist, welche jeweils nicht-lineare bzw. abgewinkelte Kanäle 8 begrenzen. Ähnlich wie bei der Ausführungsform gemäß Fig. 2 und 3 sind die Kanäle 8 jeweils im wesentlichen rechtwinkelig ausgebildet und münden an jeweils aneinander angrenzenden Seiten- bzw. Begrenzungsflächen der Basisfläche 3.

Bei der Ausführungsform gemäß Fig. 4 ist weiters ersichtlich, daß die Kanäle im mittleren Bereich bzw. Abschnitt der Kühlvorrichtung 2 eine größere Höhe aufweisen als in dem Randbereich, so daß sich in dem mittleren Bereich der Kühlvorrichtung 2 ein entsprechend größerer Durchtrittsquerschnitt der Kanäle 8 ergibt.

Weiters weist bei der Ausführungsform gemäß Fig. 4 der Durchmesser der hohlen Finnen bzw. Erhebungen 5 im Vergleich zur Länge derselben sowie unter Berücksichtigung der im mittleren Bereich durch die größere Höhe der Durchtrittskanäle 8 geringeren Höhe der Finnen 5 ein Verhältnis der Höhe zum Durchmesser auf, welches etwa im Bereich von 7:1 bis maximal 10:1 liegt.

Darüber hinaus ist in Fig. 4 ersichtlich, daß durch entsprechende Formgebung der Kühlkanäle 8 in Anpassung an den lichten Querschnitt der Finnen 5 jeweils der volle, lichte Querschnitt der Finnen 5 für einen Abtransport von Wärme aus den Kanälen 8 zur Verfügung steht.

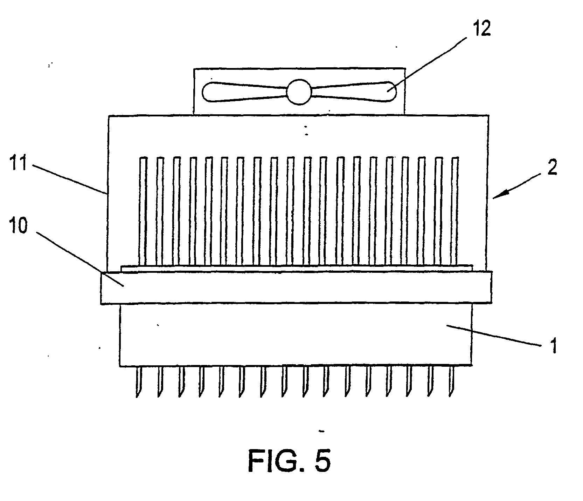

Bei der Ausbildung gemäß Fig. 5 ist ein zu kühlender Bauteil, insbesondere Chip bzw. Prozessor wiederum mit 1 bezeichnet, wobei eine schematisch mit 2 bezeichnete Kühlvorrichtung über eine im wesentlichen vollflächige Zwischenplatte 10 an dem zu kühlenden Bauteil 1 festgelegt bzw. angeordnet, insbesondere verlötet, ist. Eine derartige Zwischenplatte 10 kann für eine Verteilung der von der Oberfläche des zu kühlenden Bauteils 1 abzuführenden Wärme, insbesondere für den Fall, daß sich Teilbereiche des zu kühlenden Bauteils unterschiedlich stark erwärmen, oder für den Fall, daß durch Rippen bzw. Stege im Bereich der Basisfläche eine geringere, unmittelbare Kontaktfläche zwischen der Basisfläche der Kühlvorrichtung 2 und der Oberfläche des zu kühlenden Bauteils 1 vorliegt, Verwendung finden.

Darüber hinaus ist bei der schematischen Darstellung gemäß Fig. 5 angedeutet, daß an der Zwischenplatte 10, welche gegenüber dem zu kühlenden Bauteil 1 als auch gegenüber der Kühlvorrichtung 2 vergrößerte Außenabmessungen aufweist, eine schematische Haltevorrichtung 11 bzw. ein Rahmen angeordnet bzw. festlegbar ist, an welcher(m) beispielsweise ein schematisch mit 12 bezeichneter Ventilator 12 bzw. ein Gebläse angeordnet werden kann. Ein derartiger zusätzlicher Ventilator kann entsprechend die Kühlleistung der Kühlvorrichtung 2 erhöhen bzw. unterstützen, so daß insgesamt mit einer vergleichsweise kleinbauenden Kühlvorrichtung 2, welche im wesentlichen auf die Abmessungen des zu kühlenden Bauteils 1 abgestimmt ist, das Auslangen gefunden werden kann.

Für einen ausreichenden Wärmeabtransport bzw. eine entsprechende Kühlleistung wird die Kühlvorrichtung 2 und/oder die Zwischenplatte 10 aus wärmeleitfähigem Material, insbesondere Metall hergestellt, wobei die Kühlvorrichtung 2 beispielsweise aus Kupfer, Aluminium, Eisen, Silber oder Gold hergestellt sein kann.

Zur Minimierung des für die Herstellung der Kühlvorrichtung 2 erforderlichen Materialeinsatzes wird darüber hinaus vorgeschlagen, daß die Kühlvorrichtung 2 durch ein elektrochemisches bzw. galvanisches Abscheiden in einer Form, welche ein Negativ der herzustellenden Kühlvorrichtung 2 darstellt, hergestellt wird, so daß insbesondere Materialverluste, welche durch ein Schneiden bzw. Fräsen, wie dies bei derzeit bekannten Kühlvorrichtungen der Fall ist, vermieden werden können.

## Patentansprüche

1. Kühlvorrichtung (2) für einen Chip (1), insbesondere Prozessor, welche von dem Chip (1) abgewandt mit einer Vielzahl von im wesentlichen normal auf eine Basisfläche (3) stehenden Erhebungen bzw. Finnen (5) ausgebildet ist und an seiner zum Chip (1) gewandten Seite über die Basisfläche (3) am Chip (1) festlegbar ist, wobei die Basisfläche (3) mit einer Mehrzahl von Stegen bzw. Rippen (7) ausgebildet ist, welche insbesondere eine Mehrzahl von durchgehenden Kanälen (8) bei Anordnung der Basisfläche (3) auf dem Chip (1) ausbilden, **dadurch gekennzeichnet, daß** die Kanäle (8) nicht-linear, insbesondere abgewinkelt, in der Basisfläche (3) ausgebildet sind.

2. Kühlvorrichtung nach Anspruch 1, **dadurch gekennzeichnet, daß** die Kanäle (8) bei im wesentlichen rechtwinkeliger Basisfläche (3) jeweils im wesentlichen normal an aneinander angrenzenden bzw. benachbarten Seiten- bzw. Begrenzungsflächen münden.

3. Kühlvorrichtung nach Anspruch 1 oder 2, **dadurch gekennzeichnet, daß** die Kanäle (8) jeweils in einem mittleren Abschnitt der Basisfläche (3) eine größere Höhe normal auf die Basisfläche (3) als in Eckbereichen der Basisfläche (3) aufweisen.

4. Kühlvorrichtung nach Anspruch 1, 2 oder 3, **dadurch gekennzeichnet, daß** die Erhebungen bzw. Finnen (4, 5) eine wenigstens teilweise bogenförmige, insbesondere kreisrunde Umfangsform im Querschnitt aufweisen.

5. Kühlvorrichtung nach einem der Ansprüche 1 bis 4, **dadurch gekennzeichnet, daß** die Finnen (5) hohl ausgebildet sind und an ihren von der Basisfläche (3) abgewandten Enden jeweils eine Durchtrittsöffnung (6) aufweisen.

6. Kühlvorrichtung nach Anspruch 5, **dadurch gekennzeichnet, daß** die hohlen Innenräume der Finnen (5) wenigstens teilweise, bevorzugt im wesentlichen vollständig, in dem Bereich der Durchtrittskanäle (8) in die Basisfläche (3) münden.

7. Kühlvorrichtung nach einem der Ansprüche 1 bis 6, **dadurch gekennzeichnet, daß** die Erhebungen bzw. Finnen (4, 5) eine Höhe aufweisen, welche maximal das 12-fache, insbesondere maximal das 7-fache, der Dicke bzw. des Durchmessers der Finnen (4, 5) beträgt.

8. Kühlvorrichtung nach einem der Ansprüche 1 bis 7, **dadurch gekennzeichnet, daß** die Finnen (4, 5) eine sich zu dem von der Basisfläche (3) abgewandten Ende verjüngende Querschnittsform aufweisen.

9. Kühlvorrichtung nach einem der Ansprüche 1 bis 8, **dadurch gekennzeichnet, daß** die Finnen (4, 5) eine rauhe bzw. aufgerauhte Oberfläche aufweisen.

10. Kühlvorrichtung nach einem der Ansprüche 1 bis 9, **dadurch gekennzeichnet, daß** die Basisfläche (3) über eine Zwischenplatte (10) an dem Chip (1) festlegbar ist.

11. Kühlvorrichtung nach Anspruch 10, **dadurch gekennzeichnet, daß** die Zwischenplatte (10) mit dem Chip (1) und/oder der Basisfläche (3) verbunden, insbesondere verlötet, ist.

12. Kühlvorrichtung nach Anspruch 10 oder 11, **dadurch gekennzeichnet; daß** die Zwischenplatte (10) die Außenabmessungen des Chips (1) und/oder der Basisfläche (3) der Kühlvorrichtung (2) übersteigt.

13. Kühlvorrichtung nach einem der Ansprüche 10 bis 12, **dadurch gekennzeichnet, daß** an der Zwischenplatte (10) eine Haltevorrichtung (11) für einen Ventilator (12) vorgesehen bzw. festlegbar ist.

14. Kühlvorrichtung nach einem der Ansprüche 1 bis 13, **dadurch gekennzeichnet, daß** die Kühlvorrichtung (2) und/oder die Zwischenplatte (10) aus wärmeleitfähigem Material, insbesondere Metall, insbesondere Kupfer, Aluminium, Eisen, Silber oder Gold, hergestellt ist.

15. Kühlvorrichtung nach Anspruch 14, **dadurch gekennzeichnet, daß** die Kühlvorrichtung (2) in einem elektrochemischen Abscheidungsverfahren herstellbar ist.

16. Verfahren zur Herstellung einer Kühlvorrichtung nach einem der Ansprüche 1 bis 15, **dadurch gekennzeichnet, daß** in einer Form, welche ein Negativ der herzustellenden Kühlvorrichtung (2) darstellt, ein Metall, insbesondere Kupfer, elektrochemisch bzw. galvanisch abgeschieden wird.

## Claims

1. A cooling device (2) for a chip (1), in particular a processor, which is designed to include a plurality of projections or fins (5) arranged substantially normal to a base surface (3) on its side facing away from the chip (1) and which is fixable to the chip (1) by said base surface (3) on its side facing the chip (1), wherein the base surface (3) is designed to include a plurality of webs or ribs (7) forming, in particular, a plurality of through channels (8) with the base surface (3) arranged on the chip (1), **characterized in that** the channels (8) are formed in the base surface (3) in a non-linear and, in particular, bent manner.

2. A cooling device according to claim 1, **characterized in that** the channels (8) each open in a substantially normal manner on adjacent or neighboring lateral or boundary surfaces with the base surface (3) being substantially rectangular.

3. A cooling device according to claim 1 or 2, **characterized in that** the channels (8) in a central portion of the base surface (3) each have a larger height normal to the base surface (3) than in corner regions of the base surface (3).

4. A cooling device according to claim 1, 2 or 3, **characterized in that** the projections or fins (4, 5) have at least partially arcuate and, in particular, circular peripheral shapes in cross section.

5. A cooling device according to any one of claims 1 to 4, **characterized in that** the fins (5) are designed to be hollow, each comprising a passage opening (6) on their ends facing away from the base surface (3).

6. A cooling device according to claim 5, **characterized in that** the hollow interiors of the fins (5) open into the base surface (3) at least partially, preferably substantially completely, in the region of the passage channels (8).

7. A cooling device according to any one of claims 1 to 6, **characterized in that** the projections or fins (4, 5) have heights that amount to a maximum of 12 times and, in particular, 7 times the thickness or diameter of the fins (4, 5).

8. A cooling device according to any one of claims 1 to 7, **characterized in that** the fins (4, 5) have cross sectional shapes tapering to the ends facing away from the base surface (3).

9. A cooling device according to any one of claims 1 to 8, **characterized in that** the fins (4, 5) have coarse or roughened surfaces.

10. A cooling device according to any one of claims 1 to 9, **characterized in that** the base surface (3) is fixable to the chip (1) via an intermediate plate (10).

11. A cooling device according to claim 10, **characterized in that** the intermediate plate (10) is connected and, in particular, soldered with the chip (1) and/or the base surface (3).

12. A cooling device according to claim 10 or 11, **characterized in that** the intermediate plate (10) exceeds the external dimensions of the chip (1) and/or the base surface (3) of the cooling device (2).

13. A cooling device according to any one of claims 10 to 12, **characterized in that** a holding means (11) for a fan (12) is provided on, or fixable to, the intermediate plate (10).

14. A cooling device according to any one of claims 1 to 13, **characterized in that** the cooling device (2) and/or the intermediate plate (10) is made of a heat-conductive material, particularly a metal and, in particular, copper, aluminum, iron, silver or gold.

15. A cooling device according to claim 14, **characterized in that** the cooling device (2) is producible by an electrochemical precipitation procedure.

16. A method for producing a cooling device according to any one of claims 1 to 15, **characterized in that** a metal, particularly copper, is electromechanically or galvanically precipitated in a mold constituting a negative of the cooling device (2) to be produced.

## Revendications

1. Dispositif de refroidissement (2) pour une puce (1), en particulier un processeur, qui est réalisé à l'opposé de la puce (1) avec une multiplicité d'élévations ou d'ailettes (5) essentiellement perpendiculaires à une surface de base (3) et peut être fixé sur la puce (1), sur son côté tourné vers la puce (1), par l'intermédiaire de la surface de base (3), la surface de base (3) étant configurée avec une pluralité de traverses ou de nervures (7), qui forment en particulier une pluralité de canaux continus (8) lors du montage de la surface de base (3) sur la puce (1), **caractérisé en ce que** les canaux (8) ont une configuration non linéaire, en particulier coudée, dans la surface de base (3).

2. Dispositif de refroidissement suivant la revendication 1, **caractérisé en ce que** les canaux (8), avec une surface de base (3) essentiellement rectangulaire, débouchent chacun de façon essentiellement perpendiculaire sur des surfaces de délimitation ou latérales voisines ou mutuellement limitrophes.

3. Dispositif de refroidissement suivant l'une des revendications 1 et 2, **caractérisé en ce que** les canaux (8) présentent chacun dans une section centrale de la surface de base (3) une hauteur plus élevée perpendiculairement à la surface de base (3) que dans les zones d'angle de cette dernière.

4. Dispositif de refroidissement suivant l'une des revendications 1, 2 et 3, **caractérisé en ce que** les élévations ou ailettes (4, 5) présentent en coupe transversale une forme périphérique au moins en partie arquée, en particulier circulaire.

5. Dispositif de refroidissement suivant l'une des revendications 1 à 4, **caractérisé en ce que** les ailettes (5) ont une configuration creuse et présentent chacune un orifice de passage (6) sur leurs extrémités opposées à la surface de base (3).

6. Dispositif de refroidissement suivant la revendication 5, **caractérisé en ce que** les espaces intérieurs creux des ailettes (5) débouchent au moins en partie, de préférence essentiellement en totalité, dans la zone des canaux de passage (8) de la surface de base (3).

7. Dispositif de refroidissement suivant l'une des revendications 1 à 6, **caractérisé en ce que** les élévations ou ailettes (4, 5) présentent une hauteur égale au maximum à 12 fois, en particulier au maximum à 7 fois, l'épaisseur ou le diamètre des ailettes (4, 5).

8. Dispositif de refroidissement suivant l'une des revendications 1 à 7, **caractérisé en ce que** les ailettes (4, 5) présentent une forme de section transversale se rétrécissant en direction de l'extrémité opposée à la surface de base (3).

9. Dispositif de refroidissement suivant l'une des revendications 1 à 8, **caractérisé en ce que** les ailettes (4, 5) présentent une surface rugueuse ou rendue rugueuse.

10. Dispositif de refroidissement suivant l'une des revendications 1 à 9, **caractérisé en ce que** la surface de base (3) peut être fixée sur la puce (1) au moyen d'une plaque intermédiaire (10).

11. Dispositif de refroidissement suivant la revendication 10, **caractérisé en ce que** la plaque intermédiaire (10) est assemblée, en particulier brasée, avec la puce (1) et/ou la surface de base (3).

12. Dispositif de refroidissement suivant l'une des revendications 10 et 11, **caractérisé en ce que** la plaque intermédiaire (10) dépasse les dimensions extérieures de la puce (1) et/ou de la surface de base (3) du dispositif de refroidissement (2).

13. Dispositif de refroidissement suivant l'une des revendications 10 à 12, **caractérisé en ce qu'**un dispositif de fixation (11) pour un ventilateur (12) est prévu ou peut être fixé sur la plaque intermédiaire (10).

14. Dispositif de refroidissement suivant l'une des revendications 1 à 13, **caractérisé en ce que** le dispositif de refroidissement (2) et/ou la plaque intermédiaire (10) sont fabriqués en un matériau conducteur de chaleur, en particulier en métal, notamment en cuivre, aluminium, fer argent ou or.

15. Dispositif de refroidissement suivant la revendication 14, **caractérisé en ce que** le dispositif de refroidissement (2) peut être fabriqué dans un procédé de déposition électrochimique.

16. Procédé de fabrication d'un dispositif de refroidissement suivant l'une des revendications 1 à 15, **caractérisé en ce qu'**un métal, en particulier du cuivre, est déposé par voie électrochimique ou électrolytique dans un moule, qui représente un négatif du dispositif de refroidissement (2) à fabriquer.
